# EUROPÄISCHE PATENTSCHRIFT

(11) **EP 0 829 142 B1**
(45) Veröffentlichungstag und Bekanntmachung des Hinweises auf die Patenterteilung: **25.07.2001**
(21) Anmeldenummer: 96911929.6
(22) Anmeldetag: 30.04.1996
(51) Int. Cl.: H03L 1/02, H04M 1/72

(54) **TELEKOMMUNIKATIONSENDGERÄT**
TELECOMMUNICATION TERMINAL
TERMINAL DE TELECOMMUNICATION

(30) Priorität: 26.05.1995 DE 19519421
(43) Veröffentlichungstag der Anmeldung: 18.03.1998
(73) Patentinhaber: SIEMENS AKTIENGESELLSCHAFT, 80333 München (DE)
(72) Erfinder: LAUE, Frank, D-38321 Denkte (DE)
(86) Internationale Anmeldenummer: DE9600743
(87) Internationale Veröffentlichungsnummer: WO9637959

(56) Entgegenhaltungen:
- EP-A- 0 560 475
- WO-A-90/16113
- US-A- 5 204 975

## Beschreibung

Gegenstand des Schutzrechts ist ein Telekommunikationsendgerät, insbesondere ein Mobiltelefon, mit den Merkmalen des Oberbegriffs des Anspruchs 1.

Bei modernen, digital arbeitenden Mobiltelefonen und ähnlichen Endgeräten macht sich der Temperaturgang, dem auch ein spannungsgesteuerter Quarzoszillator unterworfen ist, nachteilig bemerkbar, z.B. dann, wenn der Einsatzort kurzfristig von drinnen nach draußen verlegt wird.

An sich sind digital temperaturkompensierte Quarzoszillatoren für einen Frequenzbereich bis zu 25MHz bekannt. Hier sind der Schwingquarz und ein Mikroprozessor zusammen mit einer Regelschaltung zur Erzeugung der Korrekturspannung von einem gemeinsamen Gehäuse umgeben. Ein solcher Quarzoszillator ist sehr aufwendig und sein Einsatz bei Telekommunikationsendgeräten, die inzwischen in großer Stückzahl nachgefragt werden, begegnet daher erheblichen Bedenken.

Aus der US-A 5 204 975 ist ein Telekommunikationsgerät bekannt, das eine Oszillatorschaltung aufweist, deren Frequenznormal einen Temperaturgang hat. Mit einem Temperatursensor wird in regelmäßigen Abständen zeitgesteuert die Temperatur abgefragt und in Abhängigkeit von der gerade gemessenen Temperatur ein Steuersignal erzeugt, das zur Temperaturkompensation der Quarzfrequenz dient. Die WO 90/16113 zeigt und beschreibt einen Oszillator, in dessen Nähe ein Temperaturfühler angeordnet ist. Bei dieser Schaltungsanordnung wird jedoch nicht die Frequenz des Quarzoszillators korrigiert, sondern der Temperaturfühler ist in der Nähe des spannungsgesteuerten Oszillators angeordnet. Hier wird also keine Korrektur der Frequenzreferenz vorgenommen sondern es wird vielmehr der spannungsgesteuerte Oszillator über einen Rechner korrigiert Auch in dieser Entgegenhaltung wird eine ständige Anpassung des Oszillators unter Kontrolle des Prozessors vorgenommen. Das Telekommunikationsgerät mit den Merkmalen des Hauptanspruchs hat den Vorteil, daß die Temperatur in der Nähe des Quarzes nur dann abgerufen wird, wenn ein Ausgangssignal des Quarzoszillators auch benötigt wird. Dadurch, daß nicht ständig eine Korrektur erfolgt, ist es möglich, in erheblichem Umfang Energie zu sparen, ohne den Rechner gleichzeitig über Gebühr zu beanspruchen. Dadurch verbessert sich die Energiebilanz eines Telekommunikationsgerätes.

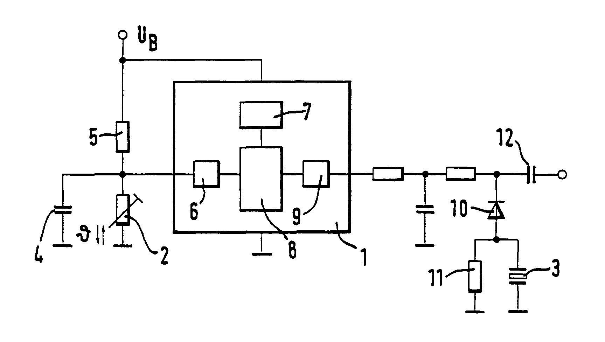

Anhand des in der Zeichnung dargestellten Blockschaltbildes wird die Erfindung näher erläutert.

Der Betrieb des Telekommunikationsendgerätes wird durch einen Mikroprozessor 1 gesteuert. Der Mikroprozessor 1 wird in Telekommunikationsgeräten üblicherweise bei jedem Kommunikationswunsch neu gestartet und verharrt in der Zwischenzeit in einem sogenannten Stand-By-Mode, um die Batteriekapazität nicht unnötig zu belasten.

In das Programm des Mikroprozessors 1 ist eine Befehlsfolge eingefügt, die bei jeder Aktivierung des Gerätes vor dem Ablauf der vom Frequenznormal abhängigen Gerätefunktionen gestartet wird. Sobald der Mikroprozessor 1 aktiviert ist, sei es durch einen Tastendruck vor einem abgehenden Gespräch oder durch ein ankommendes Rufsignal, fragt diese Befehlsfolge den momentanen Widerstandswert eines NTC-Widerstandes 2 ab, der im Gehäuse des Endgerätes, in der näheren Umgebung eines Schwingquarzes 3, angeordnet ist. In dem in der Zeichnung dargestellten Schaltungsentwurf liegt parallel zum NTC-Widerstand 2 ein Kondensator 4 von 0.1 µF. Über einen Widerstand 5 von 47 kOhm liegt der Hochpunkt des NTC-Widerstandes 2 an der Batteriespannung U_{B}, die zum Beispiel 2,5 V beträgt. Der Widerstandswert wird von einem internen AD-Wandler 6 übernommen. In einem Speicherteil 7 im Mikroprozessor 1 sind die erforderlichen Korrekturgrößen zur Nachführung der Frequenz des Schwingquarzes 3 entsprechend der vom NTC-Widerstand 2 gemessenen Temperatur abgelegt. Der vom Rechner 8 im Mikroprozessor 1 ermittelte Korrekturwert wird in einem internen DA-Wandler 9 im Mikroprozessor 1 in einen Spannungswert umgesetzt, mit dem eine Kapazitätsvariationsdiode 10 gesteuert wird, die am Hochpunkt des Schwingquarzes 3 angeschlossen ist. Der Schwingquarz 3 schwingt beispielsweise auf einer Frequenz von 150 MHz. Dem Schwingquarz 3 ist eine Induktivität 11 von 560 nH parallel geschaltet. Über einen Koppelkondensator 12 von 33 pF kann der nunmehr temperaturkompensierte Quarz mit der Oszillatorstufe verbunden werden. In vorgegebenen Zeitabständen wird die Temperaturmessung vom Mikroprozessor 1 wiederholt. um gegebenenfalls eine Temperaturänderung zu erfassen.

Die erfindungsgemäße Beschränkung der Kompensation des Temperaturganges eines Schwingquarzes auf die aktive Zeit des Mikroprozessor des Telekommunikationsendgerätes wurde erst möglich, als man erkannte, daß im Stand-By-Mode für die Erkennung eines ankommenden Rufes die Genauigkeit der Frequenz des Schwingquarzes nicht von Bedeutung ist.

Zur Ermittlung des Korrekturwertes kann in dem Speicherteil 7 als Korrekturgröße eine Korrekturtabelle abgelegt sein. Es ist jedoch auch möglich, als Korrekturgröße die den Temperaturgang des Schwingquarzes beschreibende Funktion experimentell zu ermitteln und in dem Speicherteil 7 abzulegen, mit deren Hilfe der Rechner 8 dann den jeweiligen Korrekturwert ermittelt.

Für den Schwingquarz kann man aufgrund der Erfindung auf preiswerte Quarze mit einer größeren Temperaturdrift zurückgreifen, die zu erheblich geringeren Kosten erhältlich sind.

Durch die erfindungsgemäß erfolgende Begrenzung der Kompensation des Temperaturganges des Schwingquarzes auf die aktive Betriebsphase des Telekommunikationsgerätes wird die Batterie des Endgerätes durch die Regelschaltung kaum zusätzlich belastet. Auch bietet die Mitverwendung des geräteeigenen Mikroprozessor für die Kompensation des Temperaturganges eine Einsparung von Bauteilen und ist auch aus diesem Grund kostengünstig.

## Patentansprüche

1. Telekommunikationsgerät, insbesondere Mobiltelefon, mit einer Oszillatorschaltung, deren Frequenznormal, insbesondere ein spannungsgesteuerter Quarzoszillator, einen Temperaturgang aufweist, mit einem programmierten Mikroprozessor zur Steuerung des Ablaufs der Gerätefunktionen, der durch einen von außen gegebenen Startbefehl aktiviert wird, und mit einem in der näheren Umgehung des Frequenznormals angeordneten Temperaturfühler,
dadurch gekennzeichnet, daß der Mikroprozessor (1) derart ausgestaltet ist, daß in einem Speicherteil (7) des Mikroprozessors (1) Korrekturgrößen zur Nachführung der Frequenz des Frequenznormals abgelegt sind, daß in dem Programm des Mikroprozessors (1) eine Befehlsfolge zur Abfrage des momentanen Widerstandswertes des Temperaturfühlers (2) eingefügt ist, die vor dem Ablauf der vom Frequenznormal abhängigen Gerätefunktionen abrufbar ist, und daß aus den Korrekturgrößen eine dem momentanen Meßwert des Temperaturfühlers (2) entsprechende Korrekturspannung für das Frequenznormal (3) ermittelbar ist.

2. Telekommunikationsgerät nach Anspruch 1,
dadurch gekennzeichnet,
daß die Befehlsfolge in vorgegebenen Zeitabständen in dem Ablauf der Gerätefunktionen wiederholt wird.

## Claims

1. Telecommunications terminal, in particular mobile telephone, having an oscillator circuit whose frequency norm, in particular a voltage-controlled quartz oscillator, has a temperature response, having a programmed microprocessor for controlling the execution of the terminal functions, which is activated by a start instruction provided externally, and having a temperature sensor which is arranged in the relatively close surroundings of the frequency norm, characterized in that the microprocessor (1) is designed such that a memory part (7) of the microprocessor (1) stores correction variables for correcting the frequency of the frequency norm, in that a series of instructions for requesting the present resistance value of the temperature sensor (2) is inserted in the program in the microprocessor (1), said series of instructions being retrievable before execution of the terminal functions which are dependent on the frequency norm, and in that the correction variables can be used to ascertain a correction voltage for the frequency norm (3), said correction voltage being based on the present measured value from the temperature sensor (2).

2. Telecommunications terminal according to Claim 1,
characterized
in that the series of instructions is repeated at prescribed time intervals in the execution of the terminal functions.

## Revendications

1. Appareil de télécommunication, notamment téléphone mobile comportant un circuit d'oscillateur dont l'étalon de fréquence, notamment un oscillateur à cristal commandé en tension, comporte une courbe de température, comportant un microprocesseur programmé pour commander le déroulement des fonctionnements de l'appareil qui est activé par une instruction de démarrage donnée de l'extérieur, et comportant un capteur de température monté à proximité immédiate de l'étalon de fréquence, caractérisé en ce que le microprocesseur (1) est réalisé de telle manière qu'il est mis en mémoire dans une partie (7) de mémoire du microprocesseur (1) des grandeurs de correction pour l'asservissement de la fréquence de l'étalon de fréquence, en ce qu'il est inséré dans le programme du microprocesseur (1) une séquence d'instructions pour l'interrogation sur la valeur de résistance instantanée du capteur (2) de température qui peut être appelé avant le déroulement des fonctions de l'appareil dépendant de l'étalon de fréquence, et en ce qu'il peut être déterminé à partir des grandeurs de correction, une tension de correction pour l'étalon (3) de fréquence correspondant à la valeur de mesure instantanée du capteur (2) de température.

2. Appareil de télécommunication suivant la revendication 1, caractérisé en ce que la séquence d'instructions est répétée à intervalles de temps prescrits dans le déroulement des fonctionnements de l'appareil.
